## Europäisches Patentamt

## European Patent Office

## Office européen des brevets

(11) Veröffentlichungsnummer: **0 204 930**
**B1**

(12) # EUROPÄISCHE PATENTSCHRIFT

(45) Veröffentlichungstag der Patentschrift:
27.12.89

(51) Int. Cl.⁴: **H 02 H 11/00,** H 01 F 7/18

(21) Anmeldenummer: **86105436.9**

(22) Anmeldetag: **19.04.86**

(54) Schutzeinrichtung für einen elektromagnetischen Verbraucher.

(30) Priorität: **15.05.85 DE 3517490**

(43) Veröffentlichungstag der Anmeldung:
**17.12.86 Patentblatt 86/51**

(45) Bekanntmachung des Hinweises auf die Patenterteilung:
**27.12.89 Patentblatt 89/52**

(84) Benannte Vertragsstaaten:
**DE FR GB**

(56) Entgegenhaltungen:
**DE-A-2 536 455**
**DE-A-3 026 740**
**GB-A-2 095 065**

(73) Patentinhaber: **ROBERT BOSCH GMBH, Postfach 50, D-7000 Stuttgart 1 (DE)**

(72) Erfinder: **Harsch, Klaus, Dipl.- Ing., Schillerstrasse 37/1, D-7257 Ditzingen (DE)**
Erfinder: **Kosak, Wolfgang, Dipl.- Ing., Mendelssohnstrasse 14, D-7141 Möglingen (DE)**
Erfinder: **Werner, Peter, Dipl.- Ing., im Sommerrain 15, D-7135 Wiernsheim (DE)**

EP 0 204 930 B1

## Beschreibung

### Stand der Technik

Die Erfindung betrifft eine Schutzeinrichtung für einen elektromagnetischen Verbraucher. Aus der GB-A-2 095 065 ist eine Schutzeinrichtung für einen elektromagnetischen Verbraucher mit den Merkmalen des Oberbegriffs des Anspruchs 1 bekannt. Dabei ist die erste Schalteinrichtung mit Hilfe eines Transistors realisiert, dem eine Zener-Diode als Schutzvorrichtung parallel geschaltet ist. Darüber hinaus ist bei dieser bekannten Einrichtung in Serie zu der den Freilauf bewerkstelligenden Diode ebenfalls eine zweite Schalteinrichtung, die mit Hilfe eines Transistors realisiert ist, geschaltet.

### Vorteile der Erfindung

Die erfindungsgemäße Schutzeinrichtung für einen elektromagnetischen Verbraucher mit den kennzeichnenden Merkmalen des Hauptanspruchs hat demgegenüber den Vorteil, daß ein sicherer und universell einsetzbarer Verpolschutz realisierbar ist, der ein Minimum an Wärmeverlusten aufweist und ebenfalls die dem Verbraucher zur Verfügung stehende Spannung nicht vermindert. Auch ist aufgrund des einfachen schaltungstechnischen Aufbaus mittels handelsüblicher Bauelemente eine Kostenersparnis gegenüber den bekannten Einrichtungen gegeben.

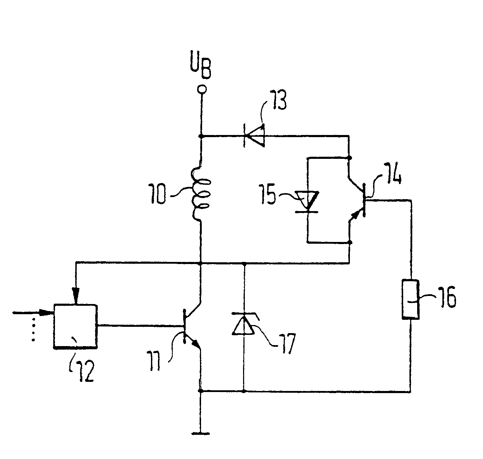

Weitere vorteilhafte Ausgestaltungen und Weiterbildungen der im Hauptanspruch angegebenen Schutzeinrichtung ergeben sich aus den abhängigen Ansprüchen sowie aus der Zeichnung und der nachfolgenden Beschreibung des Ausführungsbeispiels.

### Zeichnung

Ein Ausführungsbeispiel der Erfindung ist in der Zeichnung dargestellt und nachfolgend näher erläutert. Die einzige Figur der Zeichnung zeigt den schaltungstechnischen Aufbau einer möglichen Schutzeinrichtung.

Beschreibung des Ausführungsbeispiels

In der einzigen Figur der Zeichnung bilden ein elektromagnetischer Verbraucher 10 und ein Steuertransistor 11 eine Serienschaltung von einer Batteriespannung $U_B$ nach Masse. Die Basis des Steuertransistors 11 ist dabei an ein Steuergerät 12 angeschlossen, das in Abhängigkeit von seinen Eingangssignalen den Steuertransistor 11 ein- und ausschaltet. Bei einem der Eingangssignale des Steuergeräts 12 handelt es sich um das Potential des Verbindungspunktes des elektromagnetischen Verbrauchers 10 und des Steuertransistors 11.

Parallel zum elektromagnetischen Verbraucher 10 ist die Serienschaltung einer Freilaufdiode 13 und eines Freilauftransistors 14 geschaltet, wobei die Kathode der Freilaufdiode 13 mit der Batteriespannung $U_B$ verbunden ist, und wobei es sich bei dem Freilauftransistor 14 um einen Transistor des pnp-Typs handelt. Parallel zur Kollektor-Emitter-Strecke des Freilauftransistors 14 befindet sich dann noch eine Schutzdiode 15, deren Anode mit der Anode der Freilaufdiode 13 gekoppelt ist. Die Basis des Freilauftransistors 14 ist über einen Widerstand 16 auf Masse gelegt.

Schließlich ist zu der vom elektromagnetischen Verbraucher 10 nach Masse führenden Kollektor-Emitter-Strecke des Steuertransistor 11 noch eine Schutz-Zenerdiode 17 parallel geschaltet, deren Anode an Masse angeschlossen ist.

Bei normalem Betrieb wird der Steuertransistor 11 vom Steuergerät 12 ein- und ausgeschaltet, so daß bei durchgeschaltetem Steuertransistor 11 ein Strom über den elektromagnetischen Verbraucher 10 fließt, während bei sperrendem Steuertransistor 11 nach dem Freilaufen des Verbrauchers 10 kein Strom mehr diesen durchfließt. Der Freilauf des elektromagnetischen Verbrauchers 10 findet dabei über den Freilauftransistor 14 und die Freilaufdiode 13 statt. Dies ist möglich, weil der Freilauftransistor 14 aufgrund des nach Masse geschalteten Widerstands 16 dauernd angesteuert und im Freilauf, also wenn der Steuertransistor 11 sperrt, leitend gemacht wird.

Damit durch das Ein- und Ausschalten des Steuertransistors 11 der Freilauftransistor 14 nicht zu stark belastet wird, ist dieser Transistor durch die Schutzdiode 15 überbrückt. Besonders vorteilhaft ist es, für einen noch weitergehenden Schutz des Freilauftransistors 14 als Freilaufdiode 13 eine sogenannte Fast-Recovery-Diode zu verwenden. Dem Schutz des Steuertransistors 11 dient die Schutz-Zenerdiode 17, über die insbesondere auftretende Spannungsspitzen abgeleitet werden. Schließlich ist es durch die Zuführung des Kollektor-Potentials des Steuertransistors 11 zum Steuertransistor 12 noch möglich, innerhalb des Steuertransistors 12 eine Kurzschlußüberwachung der gesamten Schaltung zu verwirklichen.

Ist nun die gesamte Schaltung fehlerhaft an die Batteriespannung $U_B$ angeschlossen, liegt also der Emitter des Steuertransistors 11 auf dem Potential der Batteriespannung $U_B$ und die Kathode der Freilaufdiode 13 auf Masse, so hat dies zur Folge, daß der Freilauftransistor 14 andauernd sperrt. Dadurch kann kein Strom mehr über den Freilauftransistor 14 und die nachgeschaltete Freilaufdiode 13 fließen. Unabhängig davon, welchen Schaltzustand der Steuertransistor 11 einnimmt, fließt in dem beschriebenen fehlerhaften Betriebszustand ein Strom von der falsch angeschlossenen Batteriespannung $U_B$ über die Schutz-Zenerdiode 17 und den elektromagnetischen Verbraucher 10 zur ebenfalls falsch angeschlossenen Masse. Aufgrund der Dimensionierung des elektromagnetischen Verbrauchers 10 und der Batteriespannung $U_B$ ist dieser Strom jedoch für den elektromagnetischen Verbraucher 10 normalerweise nicht zu groß, so daß eine Zerstörung eines Bauelements nicht zu befürchten ist.

Insgesamt ist also bei der beschriebenen Schaltung gewährleistet, daß selbst bei einer fehlerhaften oder falschen Verbindung der Batteriespannung mit der Schaltung keine Zerstörung der Bauelemente der Schaltung zu befürchten ist. Dies wird insbesondere dadurch erreicht, daß im Freilaufkreis des elektromagnetischen Verbrauchers der Schaltung sich ein Transistor befindet, der bei richtiger Spannungsversorgung andauernd sich in seinem leitenden Schaltzustand befindet. Dadurch treten bei der beschriebenen Schaltung nur sehr geringe Verringerungen der am Verbraucher zur Verfügung stehenden Spannung auf, sowie nur vernachlässigbar geringe Wärmeverluste der einzelnen Bauelemente der Schaltung.

Besonders vorteilhaft ist es, die gesamte Schaltung im Zusammenhang mit der Steuerung und/oder Regelung von Brennkraftmaschinen zu verwenden, insbesondere für die Einspritzung von Kraftstoff und/oder die Leerlaufluftzufuhr zu den Brennräumen der Brennkraftmaschine. Dabei handelt es sich dann in besonders vorteilhafter Weise bei dem elektromagnetischen Verbraucher, z. B. um ein entsprechend ausgestaltetes Magnetventil.

## Patentansprüche

1. Schutzeinrichtung für einen elektromagnetischen Verbraucher (10) mit einer Versorgungsspannung ($U_B$) für den elektromagnetischen Verbraucher (10), mit einer die Versorgungsspannung ($U_B$) und den Verbraucher (10) verbindenden ersten Schalteinrichtung (11), sowie mit einem einen Freilauf des elektromagnetischen Verbrauchers (10) bewerkstelligenden, dem Verbraucher (10) parallel geschalteten Bauelement (13), bei der in Serie zu dem den Freilauf bewerkstelligenden Bauelement (13) eine zweite Schalteinrichtung (14) geschaltet ist, dadurch gekennzeichnet, daß der Steuereingang der zweiten Schalteinrichtung (14) dauernd mit dem Pol der Versorgungsspannung ($U_B$) verknüpft ist, dessen Potential diese Schalteinrichtung (14) bei richtiger Spannungsversorgung andauernd in ihren leitenden Zustand versetzt, bei fehlerhaftem Anschluß der Versorgungsspannung ($U_B$) jedoch andauernd sperrt, wodurch in Abhängigkeit von der Polung der Versorgungsspannung ($U_B$) der Freilauf ein- oder ausgeschaltet wird und daß die erste Schalteinrichtung (11) zwischen dem Verbraucher (10) und dem Pol der Versorgungsspannung ($U_B$) geschaltet ist, mit dem der Steuereingang der zweiten Schalteinrichtung (14) verknüpft ist.

2. Schutzeinrichtung nach Anspruch 1, dadurch gekennzeichnet, daß die zweite Schalteinrichtung (14) mit Hilfe eines Transistors realisiert ist.

3. Schutzeinrichtung nach einem der Ansprüche 1 oder 2, dadurch gekennzeichnet, daß der zweiten Schalteinrichtung (14) eine Schutzvorrichtung, insbesondere eine Diode (15) parallel geschaltet ist.

4. Schutzeinrichtung nach einem der Ansprüche 1 bis 3, dadurch gekennzeichnet, daß das den Freilauf bewerkstelligende Bauelement (13) mit Hilfe einer Diode realisiert ist.

5. Schutzeinrichtung nach einem der Ansprüche 1 bis 4, dadurch gekennzeichnet, daß die erste Schalteinrichtung (11) mit Hilfe eines Transistors realisiert ist.

6. Schutzeinrichtung nach einem der Ansprüche 1 bis 5, dadurch gekennzeichnet, daß der ersten Schalteinrichtung (11) eine Schutzvorrichtung, insbesondere eine Zenerdiode (17) parallel geschaltet ist.

7. Schutzeinrichtung nach einem der Ansprüche 1 bis 6, dadurch gekennzeichnet, daß es sich bei dem elektromagnetischen Verbraucher (10) um ein Magnetventil für die Einspritzung von Kraftstoff und/oder die Luftzufuhr zu den Brennräumen einer Brennkraftmaschine handelt.

## Claims

1. Protective device for an electromagnetic load (10) with a supply voltage ($U_B$) for the electromagnetic load (10), with a first switching device (11) connecting the supply voltage ($U_B$) and the load (10), and with a component (13) which brings about a freewheeling of the electromagnetic load (10) and which is connected in parallel with the load (10), in which protective device a second switching device (14) is connected in series with the component (13) which brings about the freewheeling, characterized in that the control input of the second switching device (14) is continuously connected to the terminal of the supply voltage ($U_B$), of which terminal the potential continuously puts this switching device (14) in its conductive state when the correct power supply is present, but continuously blocks whenever there is faulty connection of the supply voltage ($U_B$), whereby, in dependence on the polarity of the supply voltage ($U_B$), the freewheeling is switched on or off and in that the first switching device (11) is connected between the load (10) and the terminal of the supply voltage ($U_B$), with which terminal the control input of the second switching device (14) is connected.

2. Protective device according to Claim 1, characterized in that the second switching device (14) is implemented with the aid of a transistor.

3. Protective device according to one of Claims 1 or 2, characterized in that a protective device, in particular a diode (15), is connected in parallel with the second switching device (14).

4. Protective device according to one of Claims 1 to 3, characterized in that the component (13) which brings about the freewheeling is implemented with the aid of a diode.

5. Protective device according to one of Claims 1 to 4, characterized in that the first switching device (11) is implemented with the aid of a transistor.

6. Protective device according to one of Claims 1 to 5, characterized in that a protective device, in particular a Zener diode (17), is connected in parallel with the first switching device (11).

7. Protective device according to one of Claims 1 to 6, characterized in that, in the case of the electromagnetic load (10), this is a solenoid valve for the injection of fuel and/or the air feed to the combustion chambers of an internal combustion engine.

**Revendications**

1. Dispositif de protection pour une charge électromagnétique (10), un circuit (11) reliant la tension d'alimentation (U$_B$) et la charge (10) ainsi qu'un composant (13) qui permet la mise en roue libre de la charge électromagnétique (10), composant branché en parallèle sur la charge (10) et qui forme un second dispositif de commutation (14) en série sur le composant (13) qui assure la roue libre, caractérisé en ce que l'entrée de commande du second circuit de commutation (14) est reliée en permanence au pôle de la tension d'alimentation (U$_B$), pôle dont le potentiel met ce dispositif (14) en permanence à l'état conducteur lorsque l'alimentation en tension est correcte, et en cas d'erreur de branchement de la tension d'alimentation (U$_B$) il bloque toutefois en permanence ce qui met en oeuvre ou coupe la roue libre en fonction de la polarité de la tension d'alimentation (U$_B$), et en ce que le premier circuit (11) est branché entre la charge (10) et le pôle de la tension d'alimentation (UB) pour être combiné à l'entrée de commande du second circuit de commutation (14).

2. Dispositif de protection selon la revendication 1, caractérisé en ce que le second dispositif de commutation (14) est constitué par un transistor.

3. Dispositif de protection selon l'une des revendications 1 ou 2, caractérisé en ce que le second dispositif de protection (14) comporte en parallèle un dispositif de protection notamment une diode (15).

4. Dispositif de protection selon l'une des revendications 1 à 3, caractérisé en ce que le composant assurant la roue libre (13) est constitué par une diode.

5. Dispositif de protection selon l'une des revendications 1 à 4, caractérisé en ce que le premier dispositif de commutation (11) est constitué par un transistor.

6. Dispositif de protection selon l'une des revendications 1 à 5, caractérisé en ce que le premier dispositif de commutation (11) comporte en parallèle un dispositif de protection notamment une diode Zener (17).

7. Dispositif de protection selon l'une des revendications 1 à 4, caractérisé en ce que la charge électromagnétique (10) est une électrovanne d'injection du carburant et/ou de l'air comburant dans les chambres de combustion du moteur à combustion interne.